(19) Europäisches Patentamt

European Patent Office

Office européen des brevets

(11) EP 0 949 739 A2

(12) EUROPEAN PATENT APPLICATION

(43) Date of publication:
13.10.1999 Bulletin 1999/41

(51) Int. Cl.⁶: **H02J 3/38**, H02M 3/28

(21) Application number: 99106994.9

(22) Date of filing: 09.04.1999

(84) Designated Contracting States:
AT BE CH CY DE DK ES FI FR GB GR IE IT LI LU
MC NL PT SE
Designated Extension States:
AL LT LV MK RO SI

(30) Priority: 10.04.1998 JP 9908198

(71) Applicant:
Matsushita Electric Industrial Co., Ltd.
Kadoma-shi, Osaka-fu, 571-8501 (JP)

(72) Inventors:
• Nakahira, Hiroyuki
Katano-shi, Osaka (JP)
• Yamamoto, Akira
Takatsuki-shi, Osaka (JP)
• Sakiyama, Shiro
Kadoma-shi, Osaka (JP)
• Kinoshita, Masayoshi
Hirakata-shi, Osaka (JP)
• Satomi, Katsuji
Takatsuki-shi, Osaka (JP)
• Kajiwara, Jun
Kyoto-shi, Kyoto (JP)
• Yamamoto, Shinichi
Hirakata-shi, Osaka (JP)

(74) Representative:
Kügele, Bernhard et al
NOVAPAT INTERNATIONAL SA,
9, Rue du Valais
1202 Genève (CH)

(54) **Power supply apparatus**

(57)     A power supply apparatus includes a power supply circuit (100) for converting an input voltage (Vin) into an output voltage (Vout) and supplying the output voltage to a load (160). The power supply circuit (100) includes a plurality of voltage conversion circuits (110,120) having different conversion efficiencies, and a selection circuit (150) for selecting one of the plurality of voltage conversion circuits so as to improve a conversion efficiency of the power supply circuit (100).

**Description**

BACKGROUND OF THE INVENTION

1. FIELD OF THE INVENTION:

The present invention relates to a power supply apparatus for converting an input voltage into a desired voltage and supplying the desired voltage to a load.

2. DESCRIPTION OF THE RELATED ART:

A conventional power supply apparatus includes only one type of voltage conversion circuit. What type of voltage conversion circuit is adopted by the power supply apparatus is determined in accordance with the use of the system including the power supply apparatus.

Known voltage conversion circuits include a linear regulator (e.g., series regulator) and a switching regulator.

A series regulator has features of a very small generation of electric noise and a highly stable output voltage. In a series regulator, the difference between an input voltage $V_{in}$ and an output voltage $V_{out}$ is applied to both of two ends of a control transistor. The current flowing through the control transistor (i.e., the input current $I_{in}$) is supplied to an external load as an output current $I_{out}$. Accordingly, the conversion efficiency $\eta_{series}$ of the series regulator is determined by the ratio between the input voltage $V_{in}$ and the output voltage $V_{out}$ regardless of the output current $I_{out}$, as represented by expression (1).

$$\eta_{series} = V_{out}{}^*I_{out}/V_{in}{}^*I_{in} = V_{out}/V_{in} \ (\because I_{out} = I_{in}) \tag{1}$$

A switching regulator has a feature that an energy loss accompanying voltage conversion is small and thus a high conversion efficiency is obtained with a small number of external components. The reason for this is that although the conversion efficiency of the switching regulator depends on the output current $I_{out}$, chopping of an input voltage $V_{in}$ realizes a high conversion efficiency of the input voltage $V_{in}$ even when the difference between the input voltage $V_{in}$ and the output voltage $V_{out}$ is relatively large. The conversion efficiency $\eta_{switch}$ of the switching regulator is represented by expression (2).

$$\eta_{switch} = V_{out}{}^*I_{out}/V_{in}{}^*I_{in} \tag{2}$$

Series regulators are used in apparatuses in which noise presents serious problems, for example, radio devices and measuring apparatuses. Switching regulators are used in, for example, systems for which low power consumption is most desired and personal computers, especially notebook computers, in which heat generation of the power supply circuit itself presents problems. In this manner, the series regulators and the switching regulators are suitably used in different fields.

In the case where an input voltage $V_{in}$ is converted into an output voltage $V_{out}$ using a series regulator, when the output voltage $V_{out}$ is smaller than the input voltage $V_{in}$, the energy loss caused by the control transistor is excessively large. As a result, the conversion efficiency $\eta_{series}$ is lowered. However, the conversion efficiency $\eta_{series}$ is substantially constant with respect to the output current since the self current is sufficiently small.

Unlike the series regulator, the switching regulator requires a complicated circuit configuration and operation and requires a large amount of energy to operate the conversion circuit itself. When the output current $I_{out}$ is large, the operation energy of the conversion circuit is relatively small. Therefore, the reduction in the conversion efficiency $\eta_{switch}$ is negligible. However, when the output current $I_{out}$ is small, the operation energy is relatively large. Therefore, the conversion efficiency $\eta_{switch}$ is reduced to a non-negligible extent.

SUMMARY OF THE INVENTION

A power supply apparatus according to the present invention includes a power supply circuit for converting an input voltage into an output voltage and supplying the output voltage to a load. The power supply circuit includes a plurality of voltage conversion circuits having different conversion efficiencies, and a selection circuit for selecting one of the plurality of voltage conversion circuits so as to improve a conversion efficiency of the power supply circuit.

In one embodiment of the invention, the plurality of voltage conversion circuits are three or more voltage conversion circuits.

In one embodiment of the invention, the power supply circuit further includes a detection circuit for detecting the output current flowing from the power supply circuit to the load, wherein the selection circuit selects one of the plurality of voltage conversion circuits in accordance with the output current.

In one embodiment of the invention, the plurality of voltage conversion circuits include a series regulator and a switching regulator.

In one embodiment of the invention, the load is a semiconductor device including at least one function block. The semiconductor device is operable in each of a plurality of operation modes. The selection circuit receives a mode signal indicating one of the operation modes in which the semiconductor device operates and selects one of the plurality of voltage conversion circuits in accordance with the mode signal.

In one embodiment of the invention, the power supply circuit further includes a path switching circuit for switching a path between the voltage conversion circuit selected in accordance with the mode signal and the semiconductor device.

In one embodiment of the invention, the plurality of voltage conversion circuits include a series regulator and a switching regulator. The semiconductor device includes a memory and an operation circuit, and is operable at least in a first mode and a second mode. The path switching circuit switches the path so as to supply the output voltage from the series regulator selected by the selection circuit to the memory in the first mode. The path switching circuit switches the path so as to supply the output voltage from the switching regulator selected by the selection circuit to the memory and the operation circuit in the second mode.

In one embodiment of the invention, the plurality of voltage conversion circuits include a first series regulator, a second series regulator and a switching regulator. The semiconductor device includes a memory, a first operation circuit and a second operation circuit, and is operable at least in a first mode, a second mode and a third mode. The path switching circuit switches the path so as to supply the output voltage from the first series regulator selected by the selection circuit to the memory in the first mode. The path switching circuit switches the path so as to supply the output voltage from the second series regulator selected by the selection circuit to the memory and the first operation circuit in the second mode. The path switching circuit switches the path so as to supply the output voltage from the switching regulator selected by the selection circuit to the memory, the first operation circuit and the second operation circuit in the third mode.

According to the present invention, a power supply apparatus is provided having an improved conversion efficiency as a result of selecting one of a plurality of voltage conversion circuits. Thus, the power consumption of the power supply apparatus can be lowered.

Further according to the present invention, a power supply apparatus is provided having an improved conversion efficiency with respect to at least a prescribed range of output current as a result of selecting one of a plurality of voltage conversion circuits in accordance with the output current flowing from the power supply apparatus to a load.

Still further according to the present invention, a power supply apparatus is provided having an improved conversion efficiency in each of various modes of a semiconductor device as a result of selecting one of a plurality of voltage conversion circuits in accordance with a mode signal indicating the operation mode of the semiconductor device.

Moreover, power is prevented from being supplied to circuits which do not require power by switching a path between the voltage conversion circuit which is selected in accordance with the mode signal and the semiconductor device. Thus, current leak generated in a semiconductor device can be reduced. As a result, the power consumption of the semiconductor device can be lowered.

Thus, the invention described herein makes possible the advantage of providing a power supply apparatus having an improved conversion efficiency through combination of a plurality of voltage conversion circuits.

This and other advantages of the present invention will become apparent to those skilled in the art upon reading and understanding the following detailed description with reference to the accompanying figures.

BRIEF DESCRIPTION OF THE DRAWINGS

Figure **1** is a block diagram showing a structure of a power supply circuit **100** in a first example according to the present invention;

Figure **2** is a graph illustrating the relationship between the output current $I_{out}$ and the voltage conversion efficiency $\eta$ in the first example;

Figure **3** is a block diagram showing a structure of a power supply circuit **200** in a second example according to the present invention;

Figure **4** is a graph illustrating the relationship between the output current $I_{out}$ and the voltage conversion efficiency $\eta$ in the second example;

Figure **5** shows an exemplary configuration of a series regulator **210**;

Figure **6** shows an exemplary configuration of a switching regulator **220**;

Figure **7** shows a waveform of a current flowing through a coil **L** of an LC filter **230** and a waveform of a voltage applied to both two ends of the coil **L** in the second example;

Figure **8** shows an exemplary configuration of a current monitor **140** and a selection circuit **150**;

Figure **9** is a block diagram showing a structure of a semiconductor device **300** in a third example according to the present invention;

Figure **10** is a block diagram showing a structure of a power supply apparatus **560** in a fourth example according to the present invention;

Figure **11** shows an exemplary configuration of a path switching circuit **530** in the fifth example;

Figure **12** shows the relationship between a path switching signal **552** output from a CPU **550** and function blocks to which power is supplied in the fourth example;

Figure **13** is a block diagram showing a structure of a power supply apparatus **660** in a fifth example according to the present invention;

Figure **14** is a graph showing the relationship between the output current $I_{out}$ and the voltage conversion efficiency $\eta$ in the fifth example;

Figure **15** shows an exemplary configuration of a path switching circuit **630** in the sixth example;

Figure **16** shows the relationship between a path switching signal **552** output from a CPU **550** and function blocks to which power is supplied in the sixth example;

Figure **17A** shows an exemplary configuration of a series regulator **210a** in the sixth example; and

Figure **17B** shows an exemplary configuration of a series regulator **210b** in the sixth example.

DESCRIPTION OF THE EMBODIMENTS

Hereinafter, the present invention will be described by way of illustrative examples with reference to the accompanying drawings.

(Example 1)

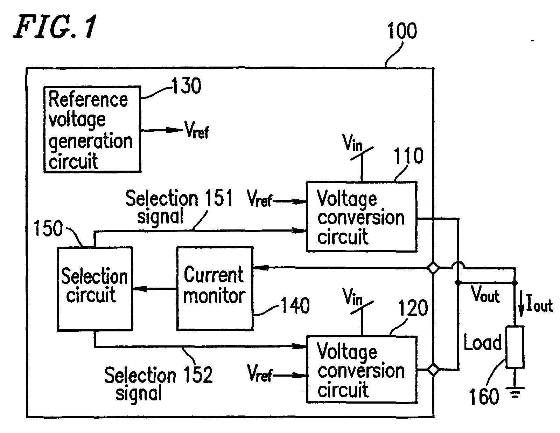

Figure **1** is a block diagram showing a structure of a power supply circuit **100** in a first example according to the present invention.
A power supply circuit **100** converts an input voltage $V_{in}$ into a desired voltage and supplies the desired voltage to a load **160** as an output voltage $V_{out}$. The load **160** is provided outside the power supply circuit **100**.
The power supply circuit **100** includes voltage conversion circuits **110** and **120**, a current monitor **140** for monitoring an output current $I_{out}$ flowing from the power supply circuit **100** to the load **160**, a selection circuit **150** for selecting one of the voltage conversion circuits **110** and **120** in accordance with a detection signal from the current monitor **140**, and a reference voltage generation circuit **130** for generating a reference voltage $V_{ref}$.
The voltage conversion circuits **110** and **120** convert the input voltage $V_{in}$ into the output voltage $V_{out}$ in different ways from each other.
In the example shown in Figure 1, the power supply circuit **100** includes two voltage conversion circuits. The present invention is not limited to this, and the power supply circuit **100** can include three or more voltage conversion circuits.
The current monitor **140** monitors the output current $I_{out}$ and outputs a detection signal which indicates whether the current value of the output current $I_{out}$ is larger or smaller than a prescribed current value $I_x$.
The selection circuit **150** outputs selection signals **151** and **152**. The selection signal **151** is supplied to the voltage conversion circuit **110**, and the selection signal **152** is supplied to the voltage conversion circuit **120**. The selection circuit **150** determines which one of the selection signals **151** and **152** should be activated in accordance with the detection signal from the current monitor **140**.

For example, when the selection signal **151** is activated, the voltage conversion circuit **110** is selected, and when the selection signal **152** is activated, the voltage conversion circuit **120** is selected.

The load **160** is commonly connected to an output of the voltage conversion circuit **110** and an output of the voltage conversion circuit **120**. When the voltage conversion circuit **110** is selected, an output from the voltage conversion circuit **110** is supplied to the load **160** as the output voltage $V_{out}$, and an output from the voltage conversion circuit **120** is put into a high impedance state. When the voltage conversion circuit **120** is selected, an output from the voltage conversion circuit **120** is supplied to the load **160** as the output voltage $V_{out}$, and an output from the voltage conversion circuit **110** is put into a high impedance state. Thus, the output from the voltage conversion circuit which is not selected is put into a high impedance state. The output current $I_{out}$ flows from the power supply circuit **100** to the load **160**. Where the resistance of the load **160** is RL, $V_{out}=I_{out}*RL$ based on the Ohm's law.

The reference voltage generation circuit **130** can have an arbitrary structure for generating a reference voltage $V_{ref}$. For example, the reference voltage generation circuit **130** can have a structure for generating the reference voltage $V_{ref}$ using a resistance ladder or a structure for generating the reference voltage $V_{ref}$ using a bandgap circuit. The reference voltage $V_{ref}$ is supplied to the voltage conversion circuits **110** and **120**.

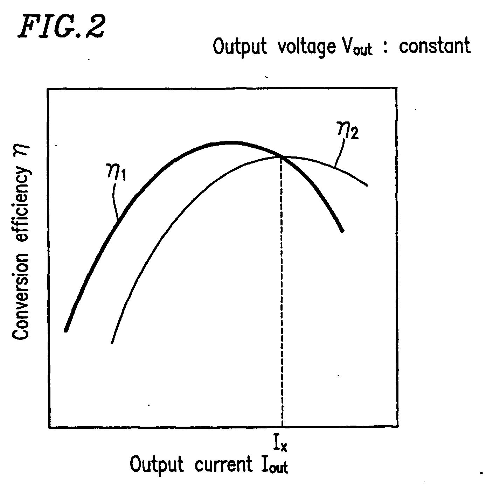

Figure **2** is a graph illustrating the relationship between the output current $I_{out}$ and the voltage conversion efficiency $\eta$. Herein, the output voltage $V_{out}$ is assumed to be constant. In Figure **2**, symbol $\eta_1$ shows the conversion efficiency of the voltage conversion circuit **110**, and symbol $\eta_2$ shows the conversion efficiency of the voltage conversion circuit **120**.

The current value at which $\eta_1=\eta_2$ is $I_x$. As shown in Figure **2**, $\eta_1>\eta_2$ when $I_{out}<I_x$; and $\eta_1<\eta_2$ when $I_{out}>I_x$. Accordingly, by designing the current monitor **140** and the selection circuit **150** so that the voltage conversion circuit **110** is selected when $I_{out}<I_x$ and the voltage conversion circuit **120** is selected when $I_{out}>I_x$, the power supply circuit **100** can have an optimum conversion efficiency regardless of the value of the output current $I_{out}$.

In the first example, a power supply circuit having a highest conversion efficiency at any value of the output current $I_{out}$ can be obtained by selecting one of a plurality of voltage conversion circuits in accordance with the value of the output current $I_{out}$.

(Example 2)

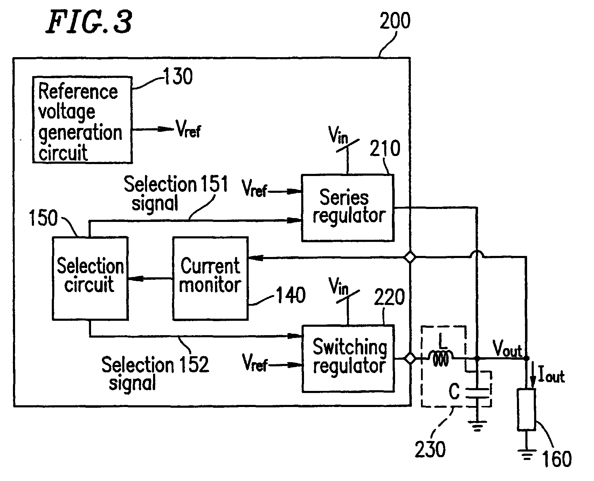

Figure **3** is a block diagram showing a structure of a power supply circuit **200** in a second example according to the present invention.

The power supply circuit **200** includes different types of voltage conversion circuits **210** and **220**. The voltage conversion circuit **210** is a series regulator, and the voltage conversion circuit **220** is a switching regulator.

In this specification, a series regulator is defined as a voltage conversion circuit for obtaining a desired voltage by dropping an input voltage $V_{in}$ using one type of variable resistor (including a transistor). A switching regulator is defined as a voltage conversion circuit for turning on or off a switching transistor, to which an input voltage $V_{in}$ is input, to generate an AC voltage and then smoothing the AC voltage to obtain a desired voltage using an LC filter.

In Figure **3**, identical elements as those described with reference to Figure **1** bear identical reference numerals therewith.

The power supply circuit **200** includes the series regulator **210**, the switching regulator **220**, a current monitor **140** for monitoring an output current $I_{out}$ flowing from the power supply circuit **200** to the load **160**, a selection circuit **150** for selecting one of the series regulator **210** and the switching regulator **220** in accordance with a detection signal from the current monitor **140**, and a reference voltage generation circuit **130** for generating a reference voltage $V_{ref}$.

For example, when a selection signal **151** output from the selection circuit **150** is activated, the series regulator **210** is selected, and an output from the series regulator **210** is output as the output voltage $V_{out}$. When a selection signal **152** from the selection circuit **150** is activated, the switching regulator **220** is selected, and an output from the switching regulator **220** is output as the output voltage $V_{out}$ through an LC filter **230**. The LC filter **230** is provided outside the power supply circuit **200** and used for smoothing the output from the switching regulator **220**.

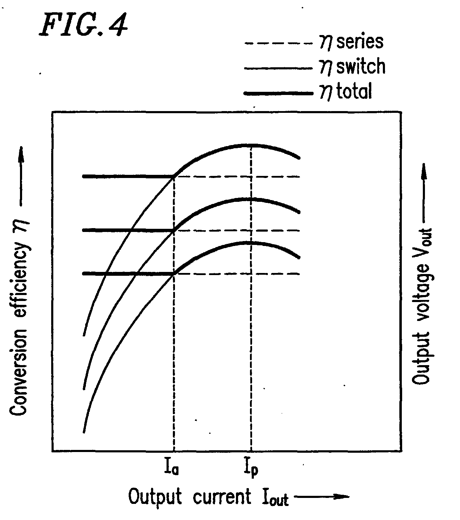

Figure **4** is a graph illustrating the relationship between the output current $I_{out}$ and the voltage conversion efficiency $\eta$. In Figure **4**, symbol $\eta_{series}$ (dashed line) shows the conversion efficiency of the series regulator **210**, and symbol $\eta_{switch}$ (thin solid lines) shows the conversion efficiency of the switching regulator **220**. Symbol $\eta_{total}$ (thick solid line) shows the conversion efficiency of the power supply circuit **200**.

As shown in Figure **4**, the conversion efficiency $\eta_{series}$ of the series regulator **210** is determined by the ratio between the input voltage $V_{in}$ and the output voltage $V_{out}$ regardless of the output current $I_{out}$ (see expression (1)).

The conversion efficiency $\eta_{switch}$ of the switching regulator **220** depends on the output current $I_{out}$. However, the switching regulator **220** can convert the input voltage $V_{in}$ into the output voltage $V_{out}$ by chopping the input voltage

$V_{in}$ at a high efficiency, even when the difference between the input voltage $V_{in}$ and the output voltage $V_{out}$ is excessively large (see expression (2)). As shown in Figure 4, the conversion efficiency $\eta_{switch}$ of the switching regulator 220 has a feature of being a peak at an output current value of $I_p$. Accordingly, the power supply circuit 200 can have a high conversion efficiency when the output current value $I_p$ can be predicted at a high accuracy. It should be noted that, as can be appreciated from Figure 4, when the value of the output current $I_{out}$ is significantly diverged from the output current value $I_p$, the conversion efficiency $\eta_{switch}$ is lowered.

The conversion efficiency $\eta_{total}$ of the power supply circuit 200 can be obtained by optimally combining the conversion efficiencies $\eta_{series}$ and $\eta_{switch}$. Specifically, when the value of the output voltage $I_{out}$ is smaller than a prescribed current value $I_a$, the series regulator 210 is selected; and when the value of the output voltage $I_{out}$ is equal to or larger than the prescribed current value $I_a$, the switching regulator 220 is selected.

The current monitor 140 detects whether the value of the output current $I_{out}$ is in the range of $I_{out}<I_a$ or in the range of $I_a \leq I_{out}$, and outputs a detection signal indicating the detection result to the selection circuit 150.

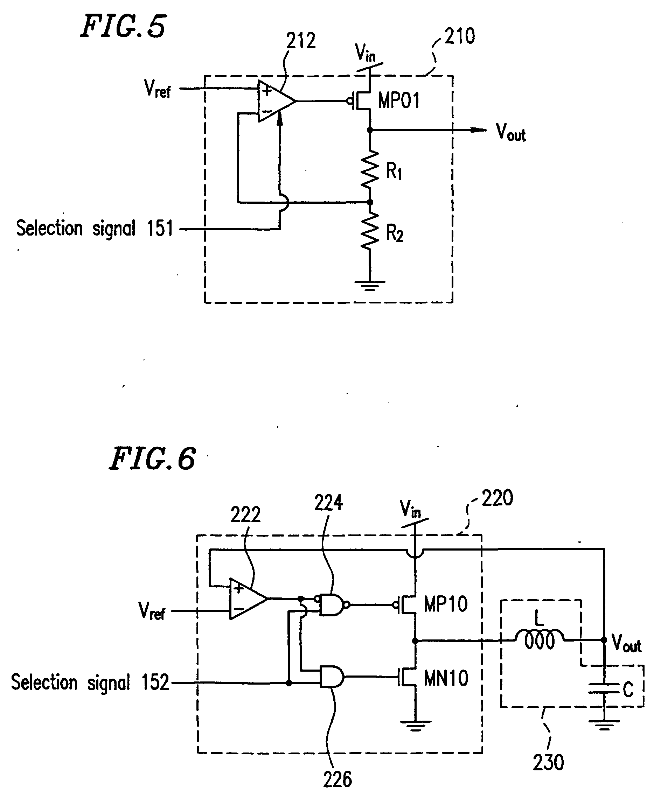

Figure 5 shows an exemplary circuit configuration of the series regulator 210.

The series regulator 210 includes a comparator 212, a PMOS transistor MP01, and resistors $R_1$ and $R_2$.

The comparator 212 receives a reference voltage $V_{ref}$ output from the reference voltage generation circuit 130 and a voltage divided by the resistors $R_1$ and $R_2$. An output of the comparator 212 is connected to a gate of the PMOS transistor MP01. The resistors $R_1$ and $R_2$ are used for dividing the output voltage $V_{out}$. A voltage obtained by dropping the output voltage $V_{out}$ using the resistor $R_1$ is supplied to one of two inputs of the comparator 212.

The output voltage $V_{out}$ and the reference voltage $V_{ref}$ fulfill the relationship represented by expression (3).

$$V_{out}=V_{ref}{}^{*}\{(R_1+R_2)/R_2\} \tag{3}$$

The selection signal 151 acts as an enable signal of the comparator 212. The comparator 212 operates only when the enable signal is at a HIGH level. More specifically, when the enable signal is at a HIGH level and $V_{ref}>V_{out}$, the comparator 212 outputs a HIGH level signal; and when the enable signal is at a HIGH level and $V_{ref}<V_{out}$, the comparator 212 outputs a LOW level signal. As a result, the PMOS transistor MP01 is turned on or off in accordance with the output voltage $V_{out}$.

When the enable signal is at a LOW level, the comparator 212 always outputs a HIGH level signal. As a result, the PMOS transistor MP01 is turned off. Thus, the output from the series regulator 210 is put into a high impedance state.

The circuit configuration shown in Figure 5 is an exemplary circuit configuration of the series regulator 210. The series regulator 210 can have an arbitrary configuration having equivalent functions as those of the circuit configuration shown in Figure 5.

Figure 6 shows an exemplary circuit configuration of the switching regulator 220.

The switching regulator 220 includes a comparator 222, logical product elements 224 and 226, and switching transistors MP10 and MN10. The switching transistor MP10 is a PMOS transistor, and the switching transistor MN10 is an NMOS transistor.

The comparator 222 acts as a switching control circuit for controlling the on and off states of the switching transistors MP10 and MN10. The comparator 222 receives a reference voltage $V_{ref}$ output from the reference voltage generation circuit 130 and an output voltage $V_{out}$. An output from the comparator 222 is supplied to an input of one of the logical product elements 224 and 226.

The selection signal 152 is input to an input to the other of the logical product elements 224 and 226. An output of the logical product element 224 is connected to a gate of the switching transistor MP10. An output of the logical product element 226 is connected to a gate of the switching transistor MN10.

Outputs from the switching transistors MP10 and MN10 are each supplied as the output voltage $V_{out}$ through the LC filter 230. The LC filter 230 includes a coil L and a capacitor C. An end of the coil L is connected to an output of the switching transistors MP10 and MN10, and the other end of the coil L is connected to the output voltage $V_{out}$. One end of the capacitor C is connected to the output voltage $V_{out}$, and the other end of the capacitor C is grounded.

In the case where the selection signal 152 is at a HIGH level, the following operation is performed. When $V_{out}>V_{ref}$, the comparator 222 outputs a HIGH level signal. As a result, the switching transistor MP10 is turned off and the switching transistor MN10 is turned on. When $V_{out}<V_{ref}$, the comparator 222 outputs a LOW level signal. As a result, the switching transistor MP10 is turned on and the switching transistor MN10 is turned off. By turning on or off the switching transistors MP10 and MN10, the current flows from the switching transistor MP10 to the LC filter 230 and from the LC filter 230 to the switching transistor MN10.

The circuit configuration shown in Figure 6 is an exemplary circuit configuration of the switching regulator 220. The switching regulator 220 can have an arbitrary configuration having equivalent functions as those of the circuit configuration shown in Figure 6.

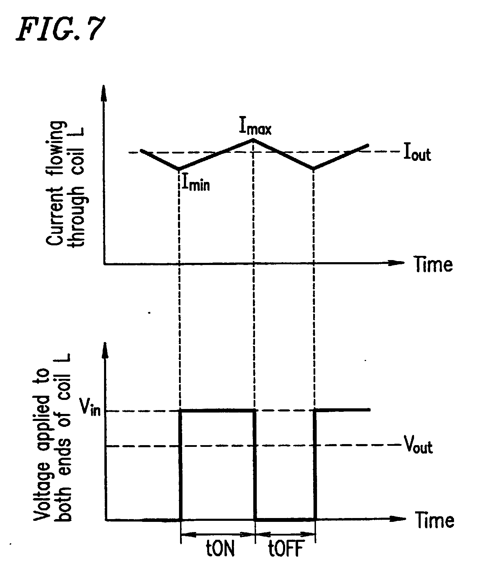

Figure 7 shows a waveform of the current flowing through the coil L of the LC filter 230, and a waveform of a voltage applied to both two ends of the coil **L**. In Figure **7**, tON indicates a time period in which the switching transistor **MP10** is on, and tOFF indicates a time period in which the switching transistor **MP10** is off.

As shown in Figure **7**, the current flowing through the coil **L** and the voltage applied to both of two ends of the coil **L** change by turning on or off the switching transistor **MP10**. When the switching transistor **MP10** is repeatedly turned on and off periodically, expression (4) is obtained since the current value when the switching transistor **MP10** is turned on from the OFF state is equal to the current value when the switching transistor **MP10** is turned off from an ON state.

$$I_{max} - I_{min} = (V_{in} - V_{out})/L*tON = V_{out}/L*tOFF \quad V_{out} = tON/(tON+tOFF)*V_{in} \tag{4}$$

Herein, $I_{max}$ indicates the maximum value of the current flowing through the coil **L**, and $I_{min}$ indicates the minimum value of the current flowing through the coil **L**.

It is appreciated from expression (4) that the output voltage $V_{out}$ can be changed by changing the duty ratio of the cycle by which the input voltage $V_{in}$ is chopped.

When the switching transistor **MP10** is on, an energy is accumulated in the coil **L** through the switching transistor **MP10**. When the switching transistor **MP10** is turned off, the switching transistor **MN10** is turned on. As a result, the energy of the coil **L** is charged in the capacitor **C** through the switching transistor **MN10**. Simply, this is the principle of the switching regulator **220**.

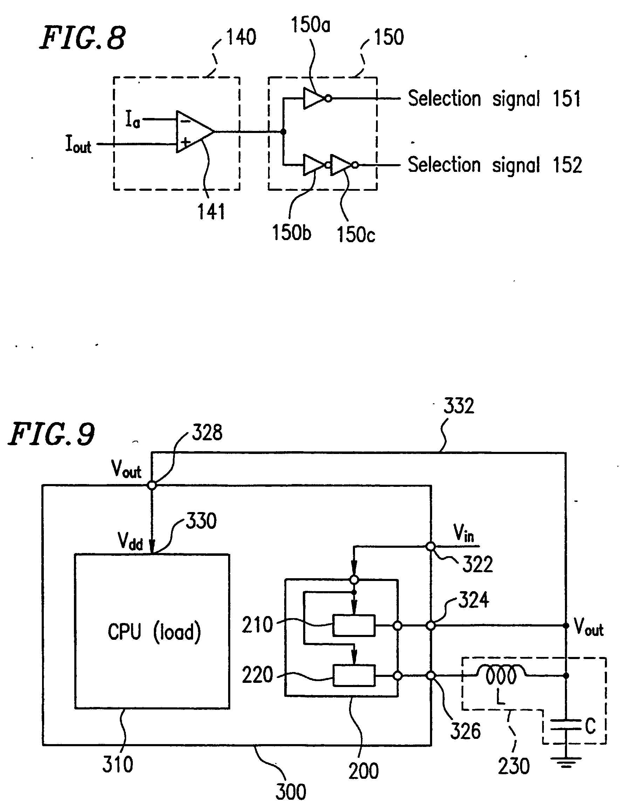

Figure **8** shows an exemplary circuit configuration of the current monitor **140** and the selection circuit **150**.

The current monitor **140** includes a current comparator **141**. A plus input of the current comparator **141** receives an output current $I_{out}$. A minus input of the current comparator **141** receives a reference current $I_a$. When the value of the current input to the plus input is equal to or greater than the value of the current input to the minus input, the current comparator **141** outputs a HIGH level signal. In other words, the current comparator **141** outputs a LOW signal when $I_{out} < I_a$, and outputs a HIGH level signal when $I_a \leq I_{out}$.

The selection circuit **150** includes inverters **150a** through **150c**.

The selection circuit **150** is configured so as to put the selection signal **151** to a HIGH level and put the selection signal **152** to a LOW level when a LOW level signal is output from the current monitor **140**, for the following reason. When $I_{out} < I_a$, $\eta_{switch} < \eta_{series}$ (see Figure **4**), and thus the series regulator **210** provides a higher conversion efficiency than the switching regulator **220**.

The selection circuit **150** is configured so as to put the selection signal **151** to a LOW level and put the selection signal **152** to a HIGH level when a HIGH level signal is output from the current monitor **140**, for the following reason. When $I_a \leq I_{out}$, $\eta_{series} \leq \eta_{switch}$ (see Figure **4**), and thus the switching regulator **220** provides a higher conversion efficiency than the series regulator **210**.

As described above, the selection signal **151** is used as an enable signal for activating the comparator **212** (Figure **5**) of the series regulator **210**. The selection signal **152** is input to the inputs of the logical product elements **224** and **226** (Figure **6**) of the switching regulator **220**.

By controlling the levels of the selection signals **151** and **152** as described above, when the series regulator **210** is selected, an output from the switching regulator **220** is in a high impedance state; and when the switching regulator **220** is selected, an output from the series regulator **210** is in a high impedance state. Thus, the output from the series regulator **210** and the output from the switching regulator **220** are prevented from colliding with each other.

In the example shown in Figure **3**, the power supply apparatus **200** includes two voltage conversion circuits. The present invention is not limited to this, and the power supply circuit **200** can include three or more voltage conversion circuits.

(Example 3)

Figure **9** is a block diagram showing a structure of a semiconductor device **300** in a third example according to the present invention. The semiconductor device **300** includes the power supply circuit **200** described in the second example. The semiconductor device **300** is formed on a single semiconductor chip.

The semiconductor device **300** further includes a CPU **310**. An output voltage $V_{out}$ from the power supply circuit **200** is supplied to the CPU **310** as a power supply voltage $V_{dd}$. As can be appreciated, in the example shown in Figure **9**, the CPU **310** is used as a load for the power supply circuit **200**.

The semiconductor device **300** can include other semiconductor circuits such as a memory and a digital signal processor (DSP). In Figure **9**, only the power supply circuit **200** and the CPU **310** are shown as the components of the semiconductor device **300** for simplicity.

As described in the second example, the power supply circuit **200** includes the series regulator **210** and the switching regulator **220**. The power supply circuit **200** receives an input voltage $V_{in}$ through a terminal **322**. The input voltage $V_{in}$ is supplied to the series regulator **210** and the switching regulator **220**.

The series regulator **210** converts the input voltage $V_{in}$ into a desired voltage and outputs the desired voltage through a terminal **324**. Thus, an output voltage $V_{out}$ is obtained.

The switching regulator **220** generates an AC voltage based on the input voltage $V_{in}$ and supplies the AC voltage to the LC filter **230** through a terminal **326**. The LC filter **230** includes the coil **L** and the capacitor **C** and is provided outside the semiconductor device **300**. The output voltage $V_{out}$ is obtained as an output from the LC filter **230**.

The output voltage $V_{out}$ is input to the semiconductor device **300** from a terminal **328** through an external line **332** provided outside the semiconductor device **300** and then supplied to a power supply port **330** of the CPU **310**.

In the case where the LC circuit **230** can be integrated inside the semiconductor device **300**, it is not necessary to supply an output from the power supply circuit **200** outside the semiconductor device **300**. In such a case, the output voltage $V_{out}$ can be supplied to the power supply port **330** of the CPU **310** through an internal line (not shown) provided inside the semiconductor device **300**.

(Example 4)

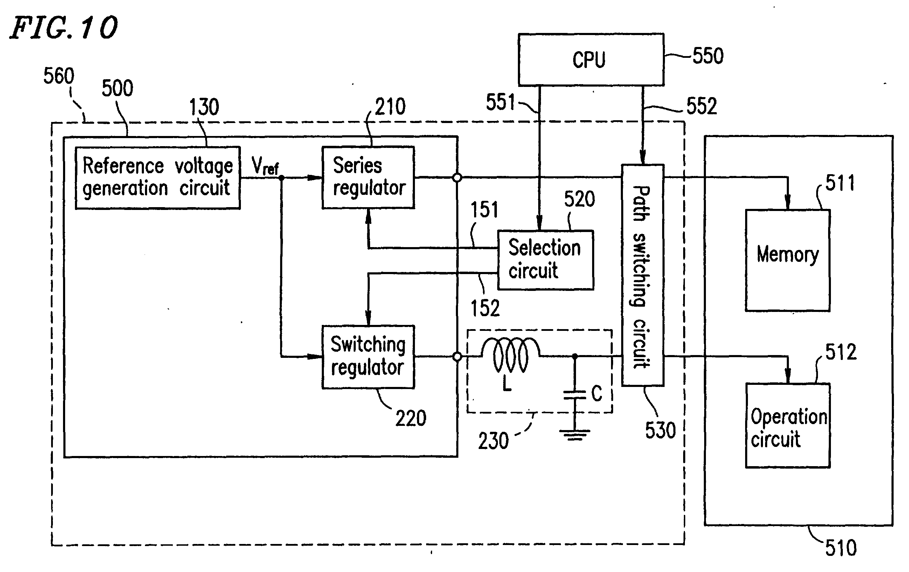

Figure **10** is a block diagram showing a structure of a power supply apparatus **560** in a fourth example according to the present invention. The power supply apparatus **560** selects one of a series regulator **210** and a switching regulator **220** included in a power supply circuit **500** in accordance with a mode signal **551** which is output from a CPU **550**.

The power supply apparatus **560** includes the power supply circuit **500**, a selection circuit **520**, a path switching circuit **530**, and an LC filter **230**.

The power supply circuit **500** includes the series regulator **210** and the switching regulator **220**. A reference voltage $V_{ref}$ generated by a reference voltage generation circuit **130** is supplied to the series regulator **210** and the switching regulator **220**. The structure and operation of the series regulator **210** and the switching regulator **220** are identical as those described in the second example and thus the descriptions thereof will not be repeated.

An output from the series regulator **210** is supplied to a semiconductor device **510** through the path switching circuit **530**. An output from the switching regulator **220** is supplied to the semiconductor device **510** through the LC filter **230** and the path switching circuit **530**. The semiconductor device **510** is used as a load for the power supply apparatus **560**.

The semiconductor device **510** has a plurality of function blocks which are independently executable. One of the plurality of function blocks is, for example, a memory **511**. Another one of the plurality of function blocks is, for example, an operation circuit **512**.

The CPU **550** outputs a mode signal **551** indicating an operation mode in which the semiconductor device **510** operates. For example, the mode signal **551** of a HIGH level indicates that the semiconductor device **510** is in a sleep mode. The mode signal **551** of a LOW level indicates that the semiconductor device **510** is in a normal mode.

During the sleep mode, the memory **511** performs only a content holding operation for holding the content of the information stored in the memory **511**, and the operation circuit **512** does not operate. During the normal mode, the memory **511** and the operation circuit **512** both operate.

The power supply apparatus **560** is structured so as to supply power only to the memory **511** during the sleep mode and to supply power to both the memory **511** and the operation circuit **512** during the normal mode. Thus, the function block or blocks to be supplied with power among the plurality of function blocks included in the semiconductor device **510** are changed in accordance with the operation mode of the semiconductor device **510**. In this manner, power is prevented from being supplied to the functional blocks which do not require power during the sleep mode. As a result, current leak can be prevented, thus reducing the power consumption of the semiconductor device **510**.

In order to perform the content holding operation, the memory **511** requires only the power which provides the output current $I_{out}$ corresponding to the current leak of the memory **511**. Accordingly, by selecting the series regulator **210** providing a high conversion efficiency at a small output current $I_{out}$ during the sleep mode, the conversion efficiency of the power supply circuit **500** is optimized.

In a conventional semiconductor circuit using a CMOS device, it is not necessary to stop the supply of the power to the semiconductor circuit during a mode in which the operation of the semiconductor circuit stops (i.e., sleep mode). The reason for this is that the current leak of each of transistors included in the semiconductor circuit is negligibly small. As the semiconductor process becomes more precise and the threshold value of the transistor becomes smaller for realizing the higher speed operation at a lower power supply voltage, the current leak is more difficult to ignore. Today, unless provision of power to circuits which do not need power during the sleep mode is stopped, low power consumption of semiconductor devices is difficult to realize. Notably, it is necessary to supply power to a memory, the content of which is erased by turning off the power. Power is supplied to the memory **511** during the sleep mode for this reason.

The selection circuit **520** selects the series regulator **210** when the semiconductor device **510** is in the sleep mode (i.e., the mode signal **551** is at a HIGH level), and selects the switching regulator **220** when the semiconductor device **510** is in the normal mode (i.e., the mode signal **551** is at a LOW level). Such a selection is achieved by determining the level of the selection signals **151** and **152** in accordance with the mode signal **551**.

The path switching circuit **530** switches the path between the power supply circuit **500** and the semiconductor device **510** in accordance with a path switching signal **552** output from the CPU **550**.

Specifically, when the series regulator **210** is selected by the selection circuit **520**, the path switching circuit **530** electrically connects the output of the series regulator **210** to the memory **511**, and electrically separates the output of the series regulator **210** from the operation circuit **512**. Thus, the output voltage $V_{out}$ from the series regulator **210** is supplied only to the memory **511** during the sleep mode.

When the switching regulator **220** is selected by the selection circuit **520**, the path switching circuit **530** electrically connects the output of the switching regulator **220** to the memory **511** and the operation circuit **512**. Thus, the output voltage $V_{out}$ from the switching regulator **220** is supplied to the memory **511** and the operation circuit **512** during the normal mode.

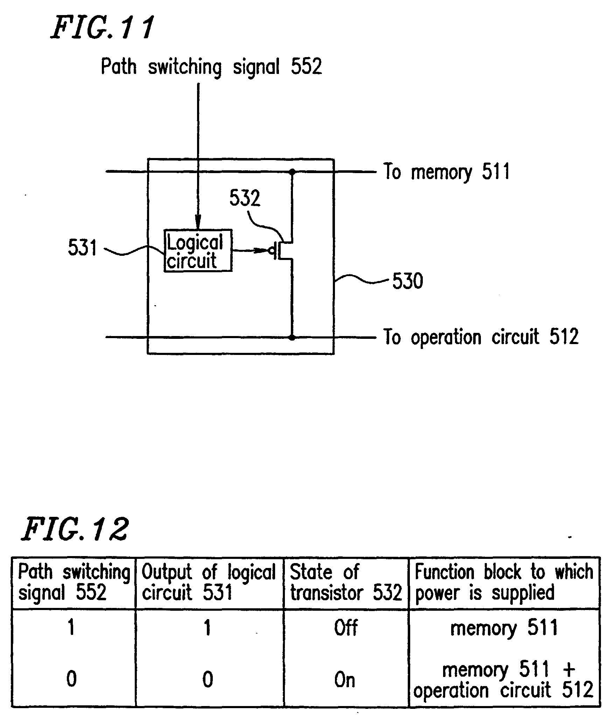

Figure **11** shows an exemplary configuration of the path switching circuit **530**. The path switching circuit **530** includes a PMOS transistor **532** and a logical circuit **531** for controlling the PMOS transistor **532** in accordance with the path switching signal **552**.

The logical circuit **531** is configured so that the PMOS transistor is turned off during the sleep mode. Thus, the output voltage $V_{out}$ from the series regulator **210** is supplied only to the memory **511** during the sleep mode.

The logical circuit **531** is configured so that the PMOS transistor is turned on during the normal mode. Thus, the output voltage $V_{out}$ from the switching regulator **220** is supplied to the memory **511** and the operation circuit **512** during the normal mode.

Figure **12** shows the relationship between the path switching signal **552** from the CPU **550** and the function blocks to which the power is supplied.

The relationship shown in Figure **12** is also realized by inputting the mode signal **551** to the path switching circuit **530** in lieu of the path switching circuit **552**. In such a case, the mode signal **551** can be directly input to a gate of the PMOS transistor **532**.

By turning on the PMOS transistor **532** while the series regulator **210** is selected by the selection circuit **520**, the output voltage $V_{out}$ from the series regulator **210** can be supplied to both the memory **511** and the operation circuit **512**. Alternatively, by turning off the PMOS transistor **532** while the switching regulator **220** is selected by the selection circuit **520**, the output voltage $V_{out}$ from the switching regulator **220** can be supplied only to the operation circuit **512**. Such provision of the output voltage $V_{out}$ can be achieved by appropriately modifying the logic of the selection circuit **520** and/or the path switching circuit **530**.

As described above, the path switching circuit **530** allows an output voltage $V_{out}$ from one voltage conversion circuit selected by the selection circuit **520** among a plurality of voltage conversion circuits included in the power supply circuit **500** to be supplied to one or more arbitrary function blocks among a plurality of function blocks included in the semiconductor device **510**. For example, in the case where the semiconductor device **510** includes a first function block and a second function block, the path switching circuit **530** can selectively supply the output voltage $V_{out}$ from a selected voltage conversion circuit only to the first function block, only to the second function block, or both the first and second function blocks.

Herein, a function block refers to an arbitrary block for executing a prescribed function. The memory and the operation circuit are examples of the function blocks, and the present invention is not limited to use of specific function blocks such as the memory and the operation circuit.

The power supply circuit **560** excluding the LC filter **230**, and the CPU **550** and the semiconductor device **510** can be formed on a single semiconductor chip. With the level of the current technology, it is desirable to provide the LC filter **230** outside the semiconductor chip. However, in the future, the LC filter **230** can be incorporated on the semiconductor chip, so that all the elements shown in Figure **10** are formed on a single semiconductor chip.

(Example 5)

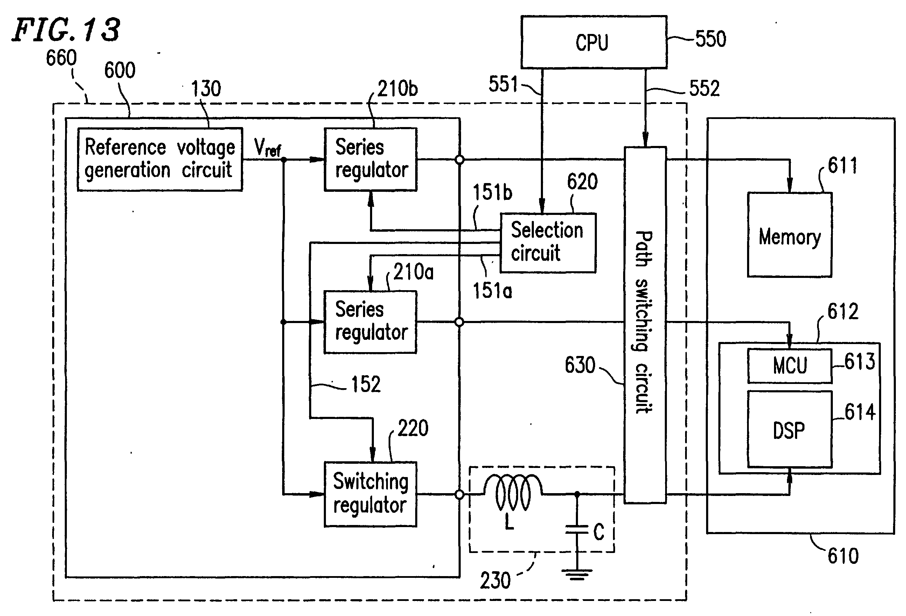

Figure **13** is a block diagram showing a structure of a power supply apparatus **660** in a fifth example according to the present invention. The power supply apparatus **660** selects one of a series regulator **210a**, a series regulator **210b** and a switching regulator **220** included in a power supply circuit **600** in accordance with a mode signal **551** which is output from a CPU **550**.

The power supply apparatus **660** includes the power supply circuit **600**, a selection circuit **620**, a path switching circuit **630**, and an LC filter **230**.

The power supply circuit **600** includes the series regulators **210a** and **210b** and the switching regulator **220**. A reference voltage $V_{ref}$ generated by a reference voltage generation circuit **130** is supplied to the series regulators **210a** and **210b**, and the switching regulator **220**.

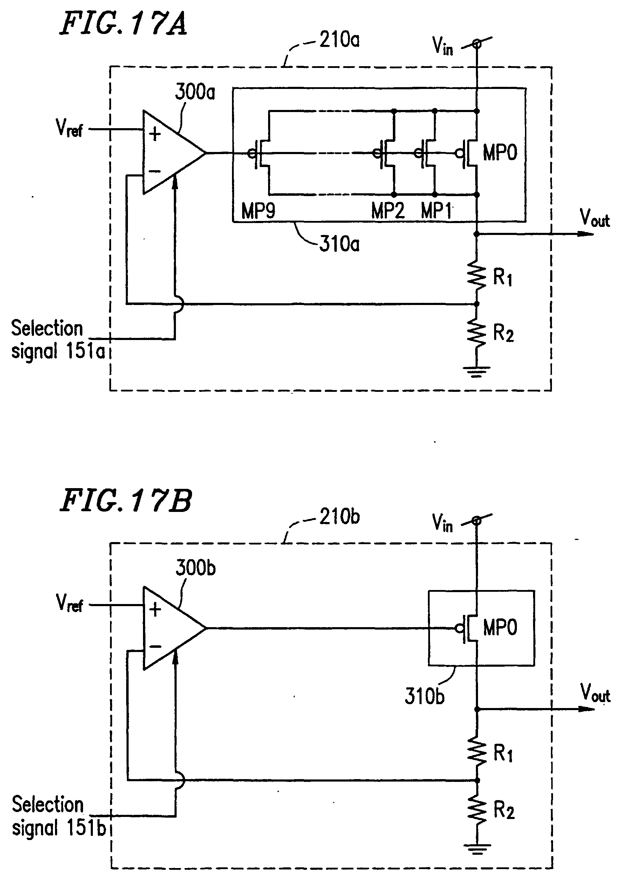

The structure of the series regulators **210a** and **210b** will be described below with reference to Figures **17A** and **17B**. The switching regulator **220** can have a structure shown in, for example, Figure **6**.

Outputs from the series regulators **210a** and **210b** are supplied to a semiconductor device **610** through the path switching circuit **630**. An output from the switching regulator **220** is supplied to the semiconductor device **610** through the LC filter **230** and the path switching circuit **630**. The semiconductor device **610** is used as a load for the power supply apparatus **660**.

The semiconductor device **610** has a plurality of function blocks which are independently executable. One of the plurality of function blocks is, for example, a memory **611**. Another one of the plurality of function blocks is, for example, an operation circuit **612**. The operation circuit **612** includes a microcontrol unit (MCU) **613** and a digital signal processor (DSP) **614**.

The CPU **550** outputs a mode signal **551** indicating an operation mode in which the semiconductor device **610** operates. For example, the mode signal **551** of "00" indicates that the semiconductor device **610** is in a sleep mode (hereinafter, referred to as a "first mode"). The mode signal of a "01" indicates that the semiconductor device **610** is in a mode in which the memory **611** and the MCU **613** are operated (hereinafter, referred to as a "second mode"). The mode signal **551** of "10" indicates that the semiconductor device **610** is in a mode in which the memory **611**, the MCU **613** and the DSP **614** are operated (hereinafter, referred to as a "third mode").

For example, when the semiconductor device **610** is used as a part of a communication system, the semiconductor device **610** is either in a wait state of waiting for transmission of information or a communication state after the information is received. The wait state corresponds to the second mode, and the communication state corresponds. to the third mode.

In the wait state, the MCU **613** and the memory **611** operate, but the DSP **614** does not operate. In the wait state, the MCU **613** performs an intermittent operation or operates at a low frequency, and thus does not consume much power. The power consumption of the MCU **613** in the wait state is, for example, 5 mA.

In the communication state, the MCU **613**, the DSP **614** and the memory **611** operate. In the communication state, more power is consumed than in the wait state. The power consumption of the MCU **613** and the DSP **614** in the communication state is, for example, 500 mA.

The sleep mode of the semiconductor device **610** corresponds to the first mode. During the sleep mode, the memory **611** performs only a content holding operation for holding the content of the information stored in the memory **611**. The content holding operation of the memory **611** is achieved by providing a current corresponding to the current leak of the memory **611** to the memory **611**. Accordingly, the amount of current required for the content holding operation of the memory **611** can be reduced by reducing the current leak of the memory **611**. The current leak of the memory **611** can be reduced by, for example, applying a biasing voltage to a substrate to raise the threshold value of the MOS transistor. Due to such an operation, the amount of current required for the content holding operation of the memory **611** can be reduced to 50 $\mu$A. The memory **611** can be a volatile memory represented by a resistor, DRAM, or SRAM.

The power supply apparatus **660** is structured so as to supply power only to the memory **611** during the first mode, to supply power to the memory **611** and the MCU **613** during the second mode, and to supply power to the memory **611**, the MCU **613** and the DSP **614** during the third mode. Thus, the function block or blocks to be supplied with power among the plurality of function blocks included in the semiconductor device **610** are changed in accordance with the operation mode of the semiconductor device **610**. In this manner, power is prevented from being supplied to the function blocks which do not require power during the sleep mode. As a result, current leak can be prevented, thus reducing the power consumption of the semiconductor device **610**.

The selection circuit **620** selects the series regulator **210b** when the semiconductor device **610** is in the first mode (i.e., the mode signal **551** is "00"), selects the series regulator **210a** when the semiconductor device **610** is in the second mode (i.e., the mode signal **551** is "01"), and selects the switching regulator **220** when the semiconductor device **610** is in the third mode (i.e., the mode signal **551** is "10"). Such a selection is achieved by determining the level of selection signals **151a**, **151b** and **152** in accordance with the mode signal **551**.

The path switching circuit **630** switches the path between the power supply circuit **600** and the semiconductor device **610** in accordance with a path switching signal **552** output from the CPU **550**.

Specifically, when the series regulator **210b** is selected by the selection circuit **620**, the path switching circuit **630** electrically connects an output of the series regulator **210b** to the memory **611**, and electrically separates the output of the series regulator **210b** from the operation circuit **612** (the MCU **613** and the DSP **614**). Thus, the output voltage $V_{out}$ from the series regulator **210b** is supplied only to the memory **611** during the first mode.

When the series regulator **210a** is selected by the selection circuit **620**, the path switching circuit **630** electrically connects an output of the series regulator **210a** to the memory **611** and the MCU **613**, and electrically separates the output of the series regulator **210a** from the DSP **614**. Thus, the output voltage $V_{out}$ from the series regulator **210b** is supplied to the memory **611** and the MCU **613** during the second mode.

When the switching regulator **220** is selected by the selection circuit **620**, the path switching circuit **630** electrically connects an output of the switching regulator **220** to the memory **611**, the MCU **613** and the DSP **614**. Thus, the output voltage $V_{out}$ from the switching regulator **220** is supplied to the memory **611**, the MCU **613** and the DSP **614** during the third mode.

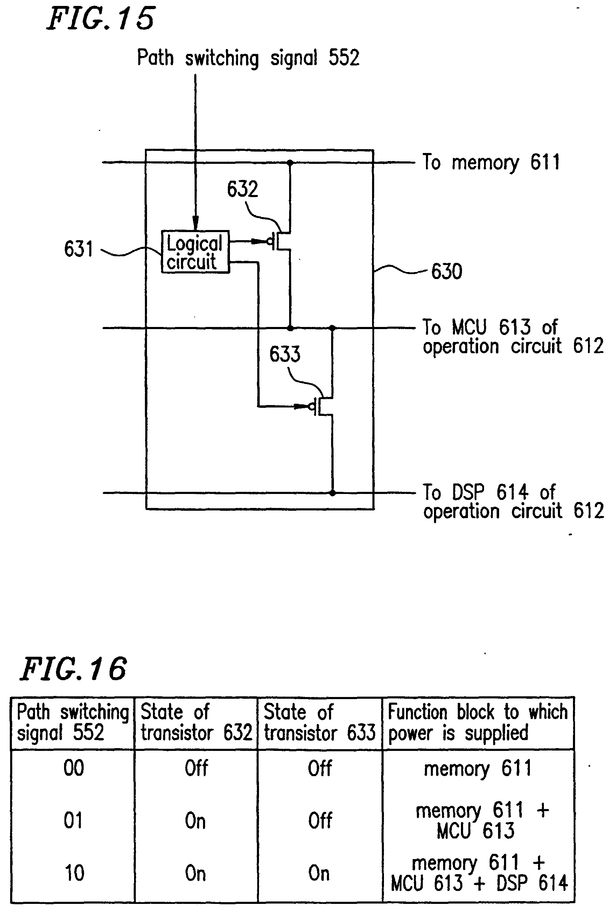

Figure 15 shows an exemplary configuration of the path switching circuit **630**. The path switching circuit **630** includes PMOS transistors **632** and **633**, and a logical circuit **631** for controlling the PMOS transistors **632** and **633** in accordance with the path switching signal **552**.

The logical circuit **631** is configured so that the PMOS transistors **632** and **633** are both turned off during the first mode. Thus, the output voltage $V_{out}$ from the series regulator **210b** is supplied only to the memory **611** during the first mode.

The logical circuit **631** is configured so that the PMOS transistor **632** is turned on and the PMOS transistor **633** is turned off during the second mode. Thus, the output voltage $V_{out}$ from the series regulator **210a** is supplied to the memory **611** and the MCU **613** during the second mode.

The logical circuit **631** is configured so that the PMOS transistors **632** and **633** are both turned on during the third mode. Thus, the output voltage $V_{out}$ from the switching regulator **220** is supplied to the memory **611**, the MCU **613** and the DSP **614** during the third mode.

Figure **16** shows the relationship between the path switching signal **552** from the CPU **550** and the function blocks to which the power is supplied.

The path switching circuit **630** allows an output voltage $V_{out}$ from one voltage conversion circuit selected by the selection circuit **620** among a plurality of voltage conversion circuits included in the power supply circuit **600** to be supplied to one or more arbitrary function blocks among a plurality of function blocks included in the semiconductor device **610**. For example, in the case where the semiconductor device **610** includes a first function block, a second function block and a third function block, the path switching circuit **630** can selectively supply the output voltage $V_{out}$ from a selected voltage conversion circuit only to the first function block, only to the second function block, only to the third function, or any combination of the first, second and third function blocks.

Figure **17A** shows an exemplary configuration of the series regulator **210a**, and Figure **17B** shows an exemplary configuration of the series regulator **210b**.

The series regulator **210a** includes an output transistor **310a** including ten PMOS transistors **MP0** through **MP9** connected in parallel. The PMOS transistors **MP0** through **MP9** have the same size.

The series regulator **210b** includes an output transistor **310b** including one PMOS transistor **MP0**. Accordingly, the amount of the output current $I_{out}$ from the series regulator **210b** is 1/10 of the amount of the output current $I_{out}$ from the series regulator **210a**.

In order that the series regulators **210a** and **210b** obtain the same response characteristics to each other, a comparator **300b** in the series regulator **210b** requires a driving performance which is only 1/10 of the driving performance of a comparator **300a** in the series regulator **210a**.

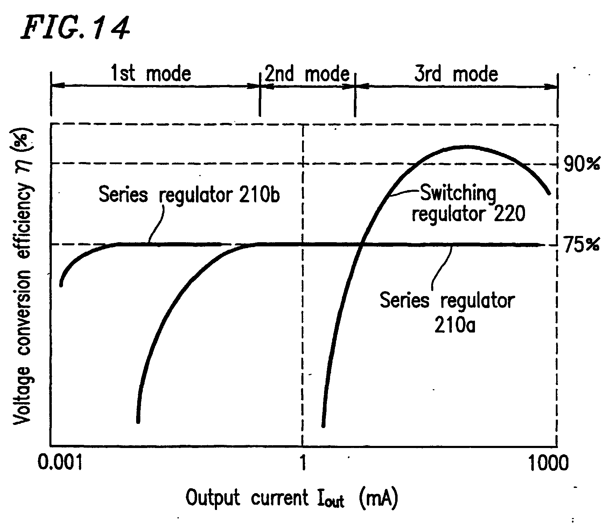

Figure **14** shows the relationship between the output current $I_{out}$ and the voltage conversion efficiency $\eta$ obtained when an input voltage $V_{in}$ (=3.3 V) is converted into an output voltage $V_{out}$ (=2.5 V).

The series regulators **210a** and **210b** and the switching regulator **220** can be designed to have the following voltage conversion characteristics. A range of the output current $I_{out}$ where the conversion efficiency of the series regulator **210b** is highest corresponds to the first mode, and a range of the output current $I_{out}$ where the conversion efficiency of the series regulator **210a** is highest corresponds to the second mode. A range of the output current $I_{out}$ where the conversion efficiency of the switching regulator **220** is highest corresponds to the third mode.

In the first mode, the series regulator **210b** is selected; in the second mode, the series regulator **210a** is selected; and in the third mode, the switching regulator **220** is selected. Thus, a voltage conversion circuit having the highest voltage conversion efficiency is selected in all the first, second and third modes.

Hereinafter, the reason why the range of the output current $I_{out}$ (load current) in which a series regulator can achieve a high voltage conversion efficiency is limited will be described. First, the reason why the conversion efficiency is lowered when the output current $I_{out}$ (load current) is excessively small will be described. Then, the reason why the conversion efficiency is lowered when the output current $I_{out}$ (load current) is excessively large will be described.

(a) Reason why the conversion efficiency is lowered when the output current $I_{out}$ (load current) is excessively large:
A series regulator requires a smaller self current needed for a conversion operation compared to a switching regulator. Accordingly, even when the load current is reduced, the conversion efficiency is not substantially lowered (see Figure **4**). However, as the load current of the series regulator approaches the level of the self current, the conversion efficiency is reduced to a non-negligible extent. As shown in Figure **14**, the conversion efficiency of the series regulator **210a** is lowered in a range where the load current is relatively small (e.g., the range corresponding to the first mode). In order to realize a high conversion efficiency in the range where the load current is relatively small, a series regulator operating at a smaller self current is required. The series regulator **210b** is designed to realize a high conversion efficiency in the range where the load current is relatively small, i.e., the range where the series regulator **210a** cannot obtain a high conversion efficiency. By combining the series regulators **210a** and **210b**, a high conversion efficiency can be realized both in the first mode and the second mode.

(b) Reason why the conversion efficiency is lowered when the output current $I_{out}$ (load current) is excessively large:

Although not shown in Figure **14**, the conversion efficiency of the series regulator **210b** becomes lower than the conversion efficiency of the series regulator **210a** in a range where the load current is relatively large (e.g., the range corresponding to the second mode). The reason for this is that since the upper limit of the load current which can be supplied by the series regulator **210b** is restricted by the current supply capability of the series regulator **210b**, as the load current increases, the conversion efficiency of the series regulator **210b** is lowered by the level corresponding to the increase of the load current. In consideration of these characteristics, the series regulator **210a** shown in Figure **17A** and the series regulator **210b** shown in Figure **17B** are configured to have different levels of current supply capability.

The power supply circuit **660** excluding the LC filter **230**, and the CPU **550** and the semiconductor device **610** can be formed on a single semiconductor chip. With the level of the current technology, it is desirable to provide the LC filter **230** outside the semiconductor chip. However, in the future, the LC filter **230** can be incorporated on the semiconductor chip, so that all the elements shown in Figure **13** are formed on a single semiconductor chip.

In the example shown in Figure **13**, the power supply circuit **600** includes three voltage conversion circuits. The present invention is not limited to this, and the power supply circuit **600** can include four or more voltage conversion circuits.

In all the above-described examples, it is not necessary to select one of the plurality of voltage conversion circuits in such a manner that the conversion efficiency of the power supply circuit is optimum. For example, the scope of the present invention includes a power supply apparatus for selecting one of a plurality of voltage conversion circuits in such a manner that the conversion efficiency of the selected voltage conversion circuit is higher than the conversion efficiency of at least one non-selected voltage conversion circuit among the plurality of voltage conversion circuits. Thus, any type of power supply apparatuses which improve the conversion efficiency by selecting one of a plurality of voltage conversion circuits are included in the scope of the present invention.

According to the present invention, a power supply apparatus is provided having an improved conversion efficiency as a result of selecting one of a plurality of voltage conversion circuits. Thus, the power consumption of the power supply apparatus can be lowered.

Further according to the present invention, a power supply apparatus is provided having an improved conversion efficiency with respect to at least a prescribed range of output current as a result of selecting one of a plurality of voltage conversion circuits in accordance with the output current flowing from the power supply apparatus to a load.

Still further according to the present invention, a power supply apparatus is provided having an improved conversion efficiency in each of various modes of a semiconductor device as a result of selecting one of a plurality of voltage conversion circuits in accordance with a mode signal indicating the operation mode of the semiconductor device.

Moreover, power is prevented from being supplied to circuits which do not require power, by switching a path between the voltage conversion circuit which is selected in accordance with the mode signal and the semiconductor device. Thus, current leak generated in a semiconductor device can be reduced. As a result, the power consumption of the semiconductor device can be lowered.

Various other modifications will be apparent to and can be readily made by those skilled in the art without departing from the scope and spirit of this invention. Accordingly, it is not intended that the scope of the claims appended hereto be limited to the description as set forth herein, but rather that the claims be broadly construed.

## Claims

1. A power supply apparatus comprising a power supply circuit for converting an input voltage into an output voltage and supplying the output voltage to a load,
   wherein the power supply circuit includes:

   a plurality of voltage conversion circuits having different conversion efficiencies, and
   a selection circuit for selecting one of the plurality of voltage conversion circuits so as to improve a conversion efficiency of the power supply circuit.

2. A power supply circuit according to claim 1, wherein the plurality of voltage conversion circuits are three or more voltage conversion circuits.

3. A power supply circuit according to claim 1, further comprising a detection circuit for detecting the output current flowing from the power supply circuit to the load, wherein the selection circuit selects one of the plurality of voltage conversion circuits in accordance with the output current.

4. A power supply circuit according to claim 1, wherein the plurality of voltage conversion circuits include a series regulator and a switching regulator.

5. A power supply circuit according to claim 1, wherein:

the load is a semiconductor device including at least one function block,
the semiconductor device is operable in each of a plurality of operation modes,
the selection circuit receives a mode signal indicating one of the operation modes in which the semiconductor device operates and selects one of the plurality of voltage conversion circuits in accordance with the mode signal.

6. A power supply circuit according to claim 5, further comprising a path switching circuit for switching a path between the voltage conversion circuit selected in accordance with the mode signal and the semiconductor device.

7. A power supply circuit according to claim 6, wherein:

the plurality of voltage conversion circuits include a series regulator and a switching regulator,
the semiconductor device includes a memory and an operation circuit, and is operable at least in a first mode and a second mode,
the path switching circuit switches the path so as to supply the output voltage from the series regulator selected by the selection circuit to the memory in the first mode, and
the path switching circuit switches the path so as to supply the output voltage from the switching regulator selected by the selection circuit to the memory and the operation circuit in the second mode.

8. A power supply circuit according to claim 6, wherein:

the plurality of voltage conversion circuits include a first series regulator, a second series regulator and a switching regulator,
the semiconductor device includes a memory, a first operation circuit and a second operation circuit, and is operable at least in a first mode, a second mode and a third mode,
the path switching circuit switches the path so as to supply the output voltage from the first series regulator selected by the selection circuit to the memory in the first mode,
the path switching circuit switches the path so as to supply the output voltage from the second series regulator selected by the selection circuit to the memory and the first operation circuit in the second mode, and
the path switching circuit switches the path so as to supply the output voltage from the switching regulator selected by the selection circuit to the memory, the first operation circuit and the second operation circuit in the third mode.

# FIG.1

100

Reference voltage generation circuit — 130 → Vref

Selection 151 signal   Vref → Voltage conversion circuit   Vin   110

150 — Selection circuit ← Current monitor — 140

Vin   120   Voltage conversion circuit ← Vref

Selection 152 signal

Vout ↓Iout

Load 160

FIG.2

Output voltage $V_{out}$ : constant

Conversion efficiency $\eta$

$\eta_1$

$\eta_2$

$I_x$

Output current $I_{out}$

*FIG.3*

FIG.4

------ η series
—— η switch
—— η total

Conversion efficiency η →

Output voltage $V_{out}$ →

$I_a$   $I_p$

Output current $I_{out}$ →

**FIG.5**

**FIG.6**

# FIG.7

## FIG.8

140    150a    150

$I_a$

$I_{out}$

141

150b    150c

Selection signal 151

Selection signal 152

## FIG.9

332

328

$V_{out}$

330

$V_{dd}$

CPU (load)

310

300

$V_{in}$

322

324

210

220

200

326

$V_{out}$

L    230    C

# FIG.10

EP 0 949 739 A2

## FIG.11

Path switching signal 552

To memory 511

532

531 — Logical circuit

530

To operation circuit 512

## FIG.12

| Path switching signal 552 | Output of logical circuit 531 | State of transistor 532 | Function block to which power is supplied |
|---|---|---|---|
| 1 | 1 | Off | memory 511 |
| 0 | 0 | On | memory 511 + operation circuit 512 |

# FIG.13

EP 0 949 739 A2

# FIG.14

# *FIG.15*

Path switching signal 552

To memory 611

632

631 — Logical circuit

630

To MCU 613 of operation circuit 612

633

To DSP 614 of operation circuit 612

# *FIG.16*

| Path switching signal 552 | State of transistor 632 | State of transistor 633 | Function block to which power is supplied |
|---|---|---|---|
| 00 | Off | Off | memory 611 |
| 01 | On | Off | memory 611 + MCU 613 |
| 10 | On | On | memory 611 + MCU 613 + DSP 614 |

## FIG.17A

## FIG.17B